# EUROPEAN PATENT APPLICATION

(11) **EP 4 391 056 A1**
(43) Date of publication of application: **26.06.2024**
(21) Application number: 23207134.0
(22) Date of filing: 31.10.2023
(51) Int. Cl.: H01L 27/02

(54) **INPUT/OUTPUT INTERFACE CELL, SEMICONDUCTOR DEVICE AND MANUFACTURING METHOD OF THE SEMICONDUCTOR DEVICE**

(30) Priority: 20.12.2022 KR 20220179613; 23.05.2023 KR 20230066059
(71) Applicant: Samsung Electronics Co., Ltd., Suwon-si, Gyeonggi-do 16677 (KR)
(72) Inventor: CHO, Yongeun, 16677 Suwon-si (KR); ROH, Hyunjeong, 16677 Suwon-si (KR); KIM, Kibum, 16677 Suwon-si (KR); KIM, Seonkyeong, 16677 Suwon-si (KR); KIM, Hayoung, 16677 Suwon-si (KR)
(74) Representative: Marks & Clerk LLP

(57) **Abstract**

A semiconductor device includes: a first I/O interface cell region having a plurality of first electrostatic discharge (ESD) diode arrangements, a first driver and a first through silicon via (TSV) disposed therein and having first wiring patterns and first via patterns for electrically connecting the plurality of first ESD diode arrangements, the first driver and the first TSV; and a second I/O interface cell region having a plurality of second ESD diode arrangements, a second driver and a second TSV disposed therein and having second wiring patterns and second via patterns for electrically connecting the second driver, the second TSV and a subset of the plurality of second ESD diode arrangements, wherein the second ESD diode arrangements other than the subset are separated from the second driver and the second TSV

## Description

### 1. Technical Field

The present disclosure relates to an input/output (I/O) interface cell, a semiconductor device and a manufacturing method of the semiconductor device.

### 2. Discussion of Related Art

A semiconductor device is an electronic component that relies on electronic properties of a semiconductor material for its function. Semiconductor devices may be manufactured both as single discrete devices and as integrated circuits (IC) chips that can number from the hundreds to the billions.

A stacked semiconductor device, such as a three-dimensional (3D) integrated circuit (3D-IC), has emerged as an efficient alternative to further reduce the physical size of the semiconductor device. In the stacked semiconductor device, individual semiconductor devices are stacked vertically on each other and are interconnected to each other using a penetrating connection portion such as a through silicon via (TSV). The 3D-IC may have reduced occupied spaces, reduced power consumption, increased yield and reduced manufacturing costs.

The 3D-IC may include an input/output (I/O) interface cell, which is a function block for interfacing vertical connections. The interface cell may include an ESD device for protecting components of the 3D-IC from electrostatic discharge (ESD). However, performance and power consumption of the 3D-IC may not be optimal due to the ESD device.

### SUMMARY

An aspect of the present disclosure may provide a semiconductor device having high utilization by enabling electrostatic discharge (ESD) performance or driving performance of an I/O (input/output) interface cell to be changed dynamically.

An aspect of the present disclosure may provide a manufacturing method to reduce time and costs for manufacturing a semiconductor device including I/O interface cells.

According to an aspect of the present disclosure, a semiconductor device includes: a first I/O interface cell region having a plurality of first electrostatic discharge (ESD) diode arrangements, a first driver and a first through silicon via (TSV) disposed therein and having first wiring patterns and first via patterns for electrically connecting the plurality of first ESD diode arrangements, the first driver and the first TSV; and a second I/O interface cell region having a plurality of second ESD diode arrangements, a second driver and a second TSV disposed therein and having second wiring patterns and second via patterns for electrically connecting the second driver, the second TSV and a subset of the plurality of second ESD diode arrangements. The second ESD diode arrangements other than the subset are separated from the second driver and the second TSV. The plurality of first ESD diode arrangements and the plurality of second ESD diode arrangements, the first driver and the second driver, and the first TSV and the second TSV have a same structure, and are disposed in a same relative position in the first I/O interface cell region and the second I/O interface cell region.

According to an aspect of the present disclosure, a manufacturing method of the semiconductor device includes: generating a layout by defining a plurality of I/O interface cell regions in a semiconductor substrate and disposing a plurality of ESD diode arrangements, one or more drivers, and a TSV in each of the plurality of I/O interface cell regions; manufacturing a plurality of masks based on the layout; forming semiconductor components constituting the plurality of ESD diode arrangements and one or more drivers in the I/O interface cell regions using the plurality of masks; determining ESD performance for each of the plurality of I/O interface cell regions; designing patterns of each of the plurality of I/O interface cell regions according to the determined ESD performance; manufacturing at least one new mask based on the designed patterns; and completing the semiconductor device by forming wiring patterns and via patterns of the semiconductor device using the plurality of masks and the new mask.

According to an aspect of the present disclosure, an I/O interface cell includes: a first driver, a second driver, a first ESD diode arrangement, a second ESD diode arrangement and a TSV. The first driver includes a first inverter and a plurality of second inverters connected in parallel to an output terminal of the first inverter. The second driver includes a plurality of third inverters. The first ESD diode arrangement includes a plurality of first unit diodes, each including a first diode connected between a first power source and an output terminal of the first driver and a second diode connected between a second power source and the output terminal of the first driver. The second ESD diode arrangement includes a plurality of second unit diodes. The TSV is electrically connected to the output terminal of the first driver. The plurality of third inverters of the second driver are selectively connected in parallel to the plurality of second inverters depending on a wiring pattern. The plurality of second unit diodes are selectively connected in parallel with the plurality of first unit diodes depending on the wiring pattern.

A semiconductor device according to an example embodiment of the present disclosure may have I/O interface cells having various ESD performances or various driving performances that can be selected, thereby increasing utilization.

A manufacturing method of a semiconductor device according to an example embodiment of the present disclosure may reduce time and costs for manufacturing the semiconductor device including I/O interface cells having various ESD performance or various driving performance.

At least some of the above and other features of the invention are set out in the claims.

### BRIEF DESCRIPTION OF DRAWINGS

The above and other aspects and features of the present disclosure will be more clearly understood from the following detailed description, taken in conjunction with the accompanying drawings, in which:
FIGS. 1 and 2 are views illustrating a 3D-IC package according to an example embodiment of the present disclosure;
FIG. 3 is a circuit diagram of an I/O interface cell according to an example embodiment of the present disclosure;
FIGS. 4A and 4B are plan views of an I/O interface cell according to an example embodiment of the present disclosure;
FIGS. 5A and 5B are cross-sectional views taken along line I-I' of FIGS. 4A and 4B, respectively;
FIGS. 6A and 6B are plan views of an I/O interface cell according to an example embodiment of the present disclosure;
FIGS. 7A to 7D are plan views of an I/O interface cell according to an example embodiment of the present disclosure;
FIGS. 8A to 8D are plan views of an I/O interface cell according to an example embodiment of the present disclosure;
FIGS. 9A to 9D are circuit diagrams of each of FIGS. 8A to 8D;
FIG. 10 is a plan view of a semiconductor device according to an example embodiment of the present disclosure; and
FIG. 11 is a flowchart illustrating a manufacturing method of a semiconductor device according to an example embodiment of the present disclosure.

### DETAILED DESCRIPTION

Hereinafter, example embodiments of the present disclosure will be described with reference to the accompanying drawings. The term "diode" is used below to refer to both a diode arrangement comprising one or more diodes, as well as to a single diode.

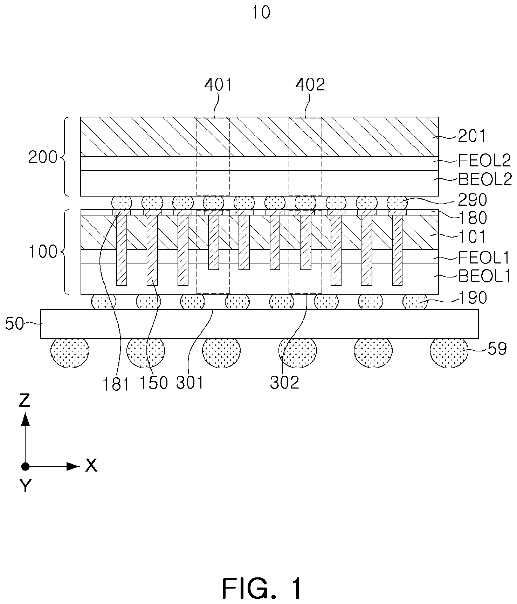

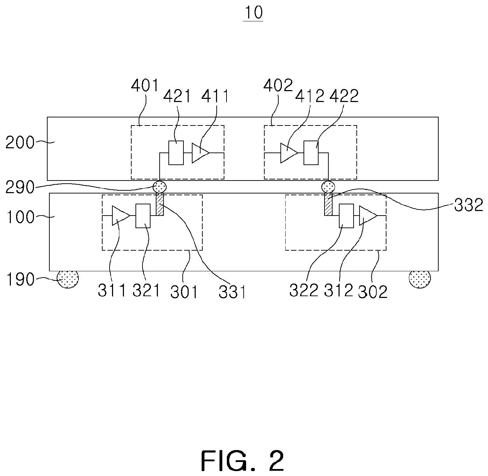

FIGS. 1 and 2 are views illustrating a 3D-IC package according to an example embodiment of the present disclosure. FIG. 1 is a cross-sectional view of the 3D-IC package, and FIG. 2 is a circuit diagram illustrating I/O interface cells of the 3D-IC.

Referring to FIG. 1, a 3D-IC package 10 may include a base substrate 50, a first semiconductor device 100, and a second semiconductor device 200.

For example, the 3D-IC package 10 may be a complete system-in package (SiP). The first semiconductor device 100 may be a general-purpose processor, and the second semiconductor device 200 may be a dynamic random access memory (DRAM), a graphics processor, an audio/video processor, a digital radio receiver, a flash memory, a communication processor, a global positioning satellite (GPS) receiver, a Bluetooth interface, a second processor, a power management unit, or combinations of other communication interfaces used by the 3D-IC package 10. These IC die types are listed only as examples, and the present disclosure does not exclude other types of IC dies.

The first semiconductor device 100 and the second semiconductor device 200 may be stacked on each other. For example, the second semiconductor device 200 may be stacked on top of the first semiconductor device 100. The first semiconductor device 100 disposed on a relatively low layer may be referred to as a bottom die, and the second semiconductor device 200 disposed on a relatively high layer may be referred to as a top die. Each of the first semiconductor device 100 and the second semiconductor device 200 may have a front surface facing an upper surface on which semiconductor components are formed in a substrate and a rear surface facing a lower surface of the substrate. In the example embodiment of FIG. 1, semiconductor devices may be stacked such that the rear surface of the first semiconductor device 100 faces the front surface of the second semiconductor device 200.

The first semiconductor device 100 may be mounted or formed on the base substrate 50 and the second semiconductor device 200 may be stacked on top of the first semiconductor device 100. For example, the base substrate 50 may be implemented as a printed circuit board (PCB).

The base substrate 50 may include several layers of conductive materials and insulating materials designed to provide an electrical connection required for the first semiconductor device 100 and the second semiconductor device 200. For example, the base substrate 50 may include conductive materials, such as a ball grid array (BGA) 59, which receive power from the outside and transmit or receive external signals. The ball grid array (BGA) 59 may include a plurality of solder bumps.

The first semiconductor device 100 may be mounted on the base substrate 50 using a process referred to as flip chip bonding. In the flip chip bonding process, the first semiconductor device 100 may be flipped, and a pad formed on the front surface of the first semiconductor device 100 may be aligned with a pad of the base substrate 50. The pads of the first semiconductor device 100 and the base substrate 50 may be connected using a conductive material 190 such as a solder bump.

The first semiconductor device 100 may include a substrate 101, a first component layer FEOL1, a first wiring layer BEOL1, and a bonding metal layer 180.

The first component layer FEOL1 may include semiconductor components deposited or grown on the substrate 101. For example, the semiconductor components may include active components such as transistors or diodes used to process or amplify electrical signals. The first component layer FEOL1 may be formed of various materials such as silicon, germanium, gallium and arsenic, depending on the purpose.

The first wiring layer BEOL1 may include wiring patterns for interconnecting the semiconductor components included in the first component layer FEOL1. For example, each of the first wiring layers BEOL1 may have a plurality of layers including wiring patterns.

The bonding metal layer 180 may include bonding pads 181 for electrical connection with the second semiconductor device 200.

The second semiconductor device 200 may include a substrate 201, a second component layer FEOL2, and a second wiring layer BEOL2. The substrate 201, the second component layer FEOL2, and the second wiring layer BEOL2 may be similar to the substrate 101, the first component layer FEOL1, and the first wiring layer BEOL1.

The first semiconductor device 100 and the second semiconductor device 200 may be turned upside down to bond the first semiconductor device 100 to the second semiconductor device 200. The pad of the second semiconductor device 200 may be aligned with the bonding pads 181 of the first semiconductor device 100. The pads of the first semiconductor device 200 and the second semiconductor device 200 may be connected using a conductive material 290 such as a microbump.

Meanwhile, the first semiconductor device 100 may include TSVs 150 for electrical connection between the first semiconductor device 100 and the second semiconductor device 200. For example, the TSVs 150 may penetrate through the first substrate 101 and the first component layer FEOL1, or may further penetrate through at least a portion of the first wiring layer BEOL1, and may electrically connect wiring patterns formed in the first wiring layer BEOL1 to the bonding pads 181 included in the bonding metal layer 180.

The first semiconductor device 100 and the second semiconductor device 200 may include a plurality of I/O interface cells for interfacing electrical connections through the TSVs 150. For example, each of the I/O interface cells of the first semiconductor device 100 may include one TSV 150. Further, each of the I/O interface cells of the second semiconductor device 200 may be electrically connected to one TSV 150.

In an embodiment, at least one of the I/O interface cells includes an ESD diode for preventing static electricity from flowing into component layers through the TSV 150 and damaging the semiconductor components, and a driving circuit for alleviating attenuation or distortion of signals transmitted through the TSV 150. In FIG. 1, some I/O interface cells 301, 302, 401 and 402 of the I/O interface cells are displayed.

Referring to FIG. 2, a circuit structure of each of the I/O interface cells 301, 302, 401 and 402 in the 3D-IC package 10 is schematically illustrated. A first transmission I/O interface cell 301 may include a transmission driver 311 (e.g., a driver circuit), an ESD diode 321, and a TSV 331. The TSV 331 may correspond to the TSV 150 described with reference to FIG. 1, and may electrically connect the first semiconductor device 100 to the second semiconductor device 200.

The ESD diode 321 may remove static electricity that may flow into the semiconductor components of the first semiconductor device 100 through the TSV 331. For example, in the process of bonding the first semiconductor device 100 and the second semiconductor device 200, when a charged first semiconductor device 100 and a charged second semiconductor device 200 get close, strong static electricity may occur and flow into the semiconductor components, and may damage the semiconductor components. The ESD diode 321 may flow static electricity introduced through the TSV 331 through power or ground.

The transmission driver 311 may transmit signals generated from the semiconductor components to the TSV 331. Despite a strong load capacitance of the TSV 331, the transmission driver 311 may have sufficient driving capability to transmit the signals without distortion.

A first reception I/O interface cell 302 may include a reception driver 312, an ESD diode 322, and a TSV 332. The reception driver 312, the ESD diode 322, and the TSV 332 may have a structure similar to that of the transmission driver 311, the ESD diode 321, and the TSV 331. For example, the reception driver 312 may amplify signals received from the second semiconductor device 200 through the TSV 332 and transmit the signals to the semiconductor components of the first semiconductor device 100.

A second reception I/O interface cell 401 may include a reception driver 411 and an ESD diode 421. Further, a second transmission I/O interface cell 402 may include a transmission driver 412 and an ESD diode 422. The reception driver 411 and the transmission driver 412 may have a structure similar to that of the transmission driver 311 and the reception driver 312. Further, the ESD diodes 421 and 422 may have a structure similar to that of the ESD diodes 321 and 322. Hereinafter, a transmission driver and a reception driver may be referred to as drivers.

Driving performance of the driver and ESD performance of the ESD diode for the semiconductor device may vary depending on performance and manufacturing environments of the semiconductor device. For example, the ESD performance required for the ESD diode may vary depending on ESD performance of equipment that bonds the first semiconductor device 100 to the second semiconductor device 200. When bonding equipment can remove static electricity of 30V or more, the ESD diode are sufficient if they have the capability to remove static electricity of 30V. When the bonding equipment can remove only static electricity of 100V or more, the ESD diode may have performance capable of removing static electricity of 100V.

Further, the driving performance required for the driver may vary depending on the load capacitance of the TSV. For example, with an increase of the load capacitance of the TSV, the driving performance of the driver may need to be increased. On the other hand, when the load capacitor of the TSV becomes relatively low, the driving performance of the driver may be limited to reduce the power consumption of the semiconductor device.

A plurality of processes may be performed on a wafer to form a semiconductor device. A plurality of the processes may be performed over a period of several months to manufacture or complete one semiconductor device. For example, wirings of the semiconductor components may be designed during a front-end process of forming fins for providing active regions such as a source and a drain of the semiconductor components to the wafer, or polysilicon constituting a gate of the semiconductor components. Further, the semiconductor device may be manufactured or completed by forming the designed wirings in a back-end process.

A driving performance condition or an ESD performance condition of a driver for the I/O interface cells of the semiconductor device may be determined or changed during the design of the semiconductor device. Instructing a change in a component or a change in a circuit may be referred to as an engineering change order (ECO). However, reconstructing semiconductor components constituting the driver or the ESD diode depending on the driving performance condition or the ESD performance condition in response to the ECO may take a huge amount of time and costs.

According to an example embodiment of the present disclosure, a plurality of semiconductor components constituting a driver or an ESD diode of an I/O interface cell are formed as compared to the ECO in the front-end process of the semiconductor device, and wirings of the plurality of semiconductor components are determined in response to the ECO. The I/O interface cells having selectable driving performance or ESD performance may be provided by wiring the plurality of semiconductor components according to the determined wirings in the back-end process.

In an embodiment, in the front-end process, even during forming of the plurality of semiconductor components constituting the driver or the ESD diode or even after forming the semiconductor components, only some of the masks for manufacturing the wiring layer are removed to select or set the driving performance or the ESD performance of the driver.

According to an example embodiment of the present disclosure, time and costs required for manufacturing the semiconductor device may be reduced in response to the driving performance condition or the ESD performance condition required for the I/O interface cells. Further, since the driving performance condition or the ESD performance condition of the I/O interface cells may be selected and changed, the utilization of the I/O interface cells may be increased.

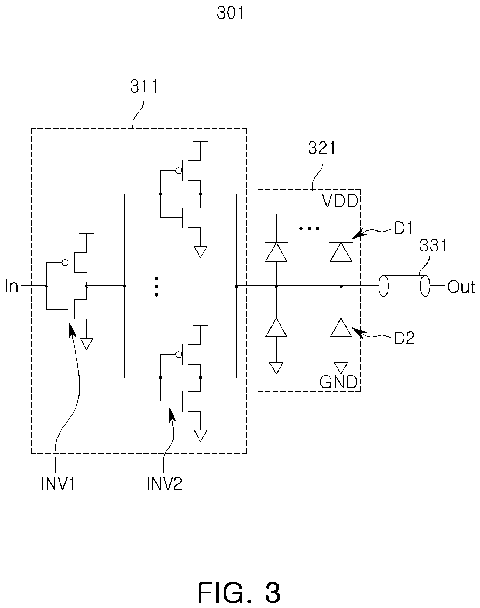

Hereinafter, an I/O interface cell and a manufacturing method of the same according to an example embodiment of the present disclosure will be described in detail with reference to FIGS. 3 to 10.

FIG. 3 is a circuit diagram of an I/O interface cell according to an example embodiment of the present disclosure.

Referring to FIG. 3, in an embodiment, an I/O interface cell 301 includes a driver 311, an ESD diode 321, and a TSV 331. An input signal In input to the driver 311 may be output as an output signal Out through the ESD diode 321 and the TSV 331. The I/O interface cell 301 of FIG. 3 may correspond to the first transmission I/O interface cell 301 described with reference to FIG. 2.

The driver 311 may include a first inverter INV1 (e.g., an inverter or logic circuit) and a plurality of second inverters INV2 (e.g., a plurality of inverter or logic circuits). The plurality of second inverters INV2 may be connected in parallel with each other. An input terminal of the first inverter INV1 may be connected to a node receiving the input signal In, and an output terminal of the first inverter INV1 may be connected to an input terminal of the second inverters INV2 connected in parallel. Further, output terminals of the second inverters INV2 connected in parallel may be connected to the ESD diode 321.

The driver 311 may provide different driving performance depending on the number of second inverters INV2 connected in parallel. For example, as the number of second inverters INV2 connected in parallel increases, stronger driving performance may be provided. According to an example embodiment of the present disclosure, in a front-end process of the semiconductor device, the predetermined number of second inverters INV2 may be formed in a region defined for the I/O interface cell 301 of the semiconductor device. Further, in the back-end process, at least some second inverters INV2 among the formed second inverters INV2 may be connected to the first inverter INV1 and the ESD diode 321 according to the driving performance determined for the I/O interface cell 301.

The ESD diode 321 may include a plurality of unit diodes connected in parallel. For example, the ESD diode 321 may include a plurality of first diodes D1 connected in parallel between a first power source VDD and an output terminal of the driver 311, and a plurality of second diodes D2 connected in parallel between a second power source GND and the output terminal of the driver 311. In the ESD diode 321, a positive voltage component of static electricity may flow to the first power source VDD through the first diodes D1, and a negative voltage component of the static electricity may flow to the second power source GND through the second diodes D2.

Hereinafter, a bundle of one first diode D1 and one second diode D2 may be referred to as a unit diode. As the number of unit diodes connected in parallel to the ESD diode 321 increases, stronger ESD performance may be provided. According to an example embodiment of the present disclosure, in the front-end process of the semiconductor device, the predetermined number of unit diodes may be formed in a region defined for the I/O interface cell 301 of the semiconductor device. Further, in a back-end process, at least some of the formed unit diodes may be connected to the driver 311 and TSV 331 according to the ESD performance determined for the I/O interface cell 301.

According to an example embodiment of the present disclosure, in the back-end process, performance and power consumption of the I/O interface cell 301 may be optimized by dynamically determining the driving performance or the ESD performance of the I/O interface cell 301. Further, time and costs for optimizing the performance and the power consumption may be reduced.

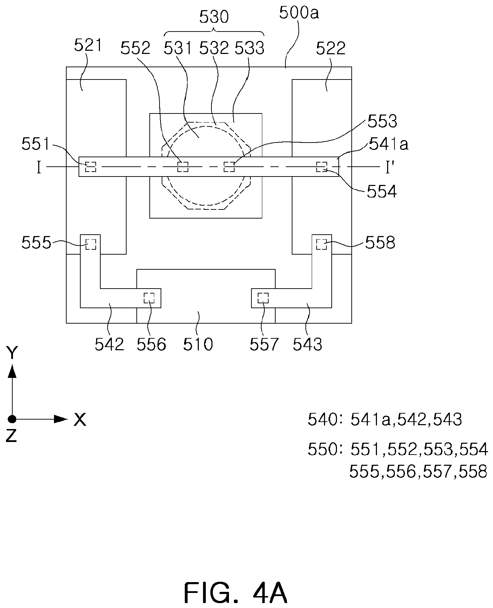

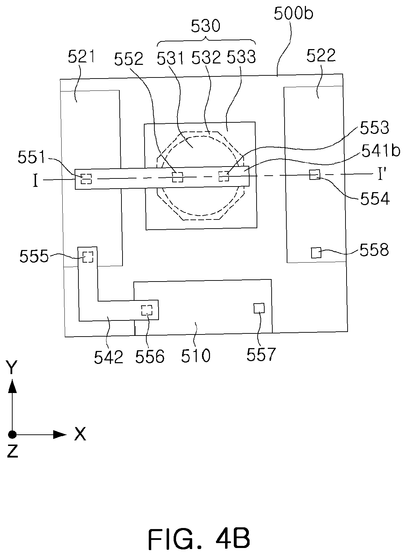

FIGS. 4A and 4B are plan views of an I/O interface cell according to an example embodiment of the present disclosure. The plan views of FIGS. 4A and 4B briefly illustrate semiconductor components disposed in a component layer and some of wirings for wiring the semiconductor components.

Referring to FIG. 4A, in an embodiment, an I/O interface cell 500a includes a driver 510, a plurality of ESD diodes 521 and 522, and an interconnection structure 530. The driver 510 may include a first inverter and a plurality of second inverters, like the driver 311 described with reference to FIG. 3. Further, the plurality of ESD diodes 521 and 522 may correspond to the ESD diode 321 described with reference to FIG. 3, each of which may include a plurality of unit diodes.

According to an example embodiment, the plurality of ESD diodes 521 and 522 may have the same ESD performance. For example, the plurality of ESD diodes 521 and 522 may have the same number of unit diodes. However, the present disclosure is not limited thereto. The plurality of ESD diodes 521 and 522 may include different numbers of unit diodes and may have different ESD performance. In an embodiment, ESD diode 521 includes a first number of unit diodes and ESD diode 522 includes a second other number of unit diodes.

In an embodiment, the interconnection structure 530 includes a TSV 531, a metal pad 532, and a wiring pattern 533. The TSV 531 may correspond to the TSV 331 described with reference to FIG. 3, and may penetrate a substrate and a component layer like the TSV 150 described with reference to FIG. 1, and extend to at least some wiring layers. The metal pad 532 may electrically connect the TSV 331 to the wiring patterns 533. The wiring pattern 533 may be included in one or more metal layers of the wiring layer and may include a plurality of wiring patterns crossing each other.

The driver 510 and the plurality of ESD diodes 521 and 522 may be disposed in consideration of a Keep-Out Zone (KOZ) defined around the interconnection structure 530. Specifically, a via hole through which the TSV 531 may penetrate may be formed in the component layer. A physical impact may be applied to the component layer to form the via hole, and a region within a certain range may be damaged from the via hole. In order to prevent the deterioration of semiconductor components, the formation of semiconductor components may be prohibited in a region within a predetermined range from the TSV 531, and the predetermined region may be referred to as the KOZ.

According to an embodiment, the KOZ includes a hard KOZ that is strictly observed and a soft KOZ that may be applied relatively flexibly. For example, the hard KOZ may be defined as a region within 3um from the TSV 531, and the soft KOZ may be defined as a region within Sum from the TSV 531. In an embodiment, no semiconductor components are formed in the hard KOZ, but some semiconductor components or wires are formed in the soft KOZ.

When the driver 510 is a logical block for transmitting a signal to the interconnection structure 530 while minimizing distortion of the signal, deterioration of the semiconductor components constituting the driver 510 needs to be prevented. Accordingly, the driver 510 may be disposed outside the soft KOZ. On the other hand, the ESD diodes 521 and 522 merely serve to remove static components and may not transmit an effective signal. Even if the semiconductor components constituting the ESD diodes 521 and 522 become somewhat deteriorated, this may have less influence on the signal transmission. Accordingly, the ESD diodes 521 and 522 are disposed outside the hard KOZ, but may be disposed within the soft KOZ. In other words, the ESD diodes 521 and 522 may be spaced apart from the TSV 531 by at least a first distance, and the driver 510 may be spaced apart from the TSV 531 by at least a second distance longer than the first distance. For example, the ESD diodes 521 and 522 may be closer to the TSV 531 than the driver 510.

In the example of FIG. 4A, a plurality of ESD diodes 521 and 522 may be disposed adjacently to the interconnection structure 530 in a first direction (X-direction). Further, the driver 510 may be disposed adjacently to the interconnection structure 530 in a second direction (Y-direction) perpendicular to the first direction (X-direction). In an embodiment, the ESD diode 521 is spaced apart from a first side of the interconnection structure 530, ESD diode 522 is spaced apart from a second side of the interconnection structure 530, and the first and second sides oppose one another.

The driver 510, the plurality of ESD diodes 521 and 522, and the interconnection structure 530 may be electrically connected to each other through wiring patterns 540 and via patterns 550 formed in the wiring layer. For example, the ESD diode 521, the interconnection structure 530, and the ESD diode 522 may be electrically connected to each other by a first wiring pattern 541a intersecting first to fourth via patterns 551 to 554. Further, the ESD diode 521 and the driver 510 may be electrically connected to each other by a second wiring pattern 542 overlapping fifth and sixth via patterns 555 and 556 on an X-Y plane, and the ESD diode 522 and the driver 510 may be electrically connected to each other by a third wiring pattern 543 overlapping the seventh and eighth via patterns 557 and 558 in a plan view.

In the example of FIG. 4A, since all of the ESD diodes 521 and 522 may be connected to the interconnection structure 530, the ESD diodes 521 and 522 may effectively remove static electricity flowing through the interconnection structure 530. Accordingly, the I/O interface cell 500a may provide ESD performance equivalent to the sum of the ESD performance of each of the ESD diodes 521 and 522.

Referring to FIG. 4B, in an embodiment, an I/O interface cell 500b includes a driver 510, a plurality of ESD diodes 521 and 522, and an interconnection structure 530, which have the same structure as that of the I/O interface cell 500a, and a plurality via patterns 551 to 558 electrically connected to the driver 510, the plurality of ESD diodes 521 and 522, and the interconnection structure 530, respectively.

However, an arrangement of wiring patterns in FIG. 4B may be different from that of FIG. 4A. For example, in FIG. 4B, a first wiring pattern 541b may extend to electrically connect the first to third via patterns 551 to 553, but may be electrically separated from the fourth via pattern 554. Further, unlike FIG. 4A, the third wiring pattern 543 may be excluded. For example, the third wiring pattern 543 of FIG. 4A may be omitted from FIG. 4B.

In the example of FIG. 4B, the ESD diode 521 is electrically connected to the driver 510 and the interconnection structure 530, and the ESD diode 522 is electrically separated from the driver 510 and the interconnection structure 530. The electrostatic components introduced through the interconnection structure 530 may be removed through the ESD diode 521. Accordingly, the I/O interface cell 500b may provide ESD performance equivalent to that of the ESD diode 521.

According to the implementation, the wiring pattern of the I/O interface cell may be designed so that the ESD diode 521 is electrically separated from the driver 510 and the interconnect structure 530, and the ESD diode 522 is electrically connected to the driver 510 and the interconnect structure 530. When the ESD diodes 521 and 522 have different ESD performance, the I/O interface cell may provide different ESD performance depending on which ESD diode is electrically connected.

Referring to FIGS. 4A and 4B, in a state in which the plurality of ESD diodes 521 and 522 are formed in the component layer, wiring patterns for connecting the plurality of ESD diodes 521 and 522 to the interconnection structure 530 may be changed to manufacture the I/O interface cells 500a and 500b having different ESD performance. According to an example embodiment of the present disclosure, the I/O interface cells 500a and 500b having different ESD performance may be manufactured by modifying only a wiring pattern included in some of a plurality of metal layers included in the wiring layer.

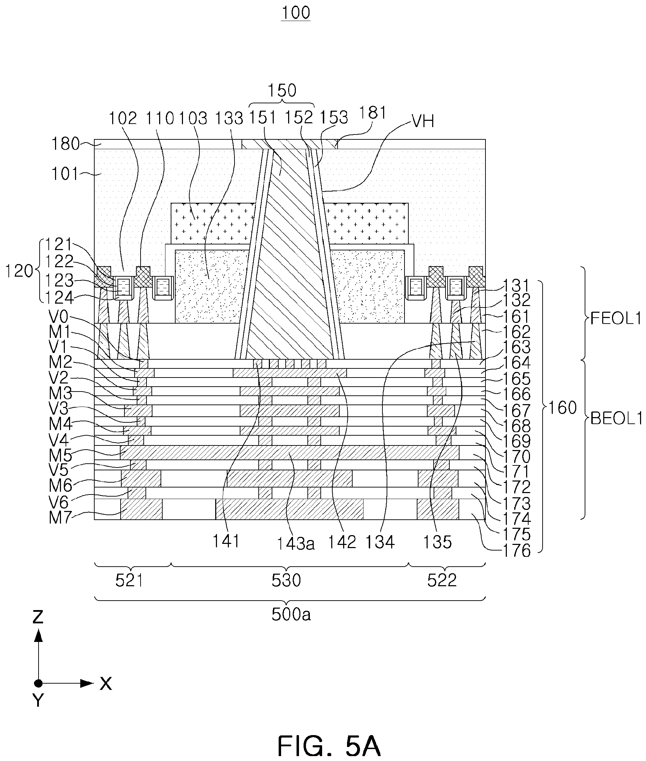

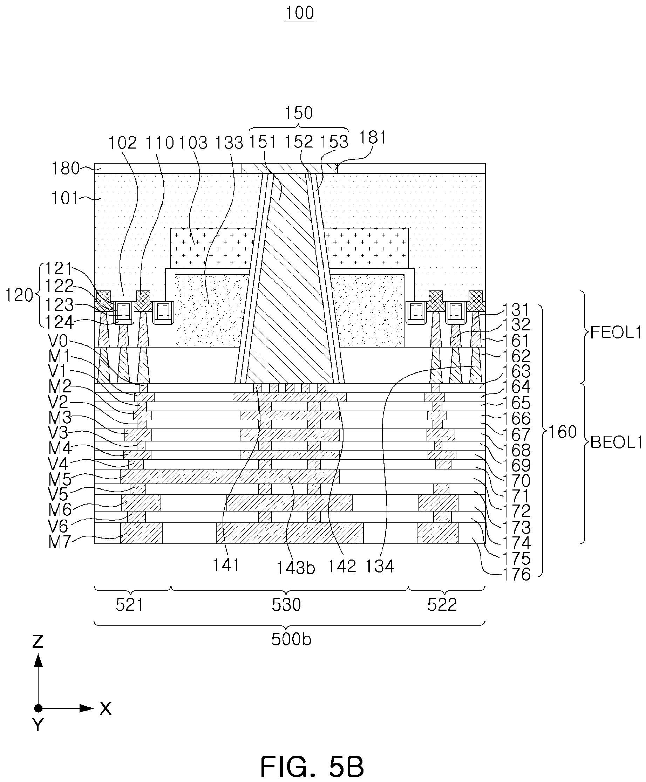

FIGS. 5A and 5B are cross-sectional views taken along line I-I' of FIGS. 4A and 4B, respectively. FIG. 5A may correspond to FIG. 4A, and FIG. 5B may correspond to FIG. 4B.

Referring to FIG. 5A, an I/O interface cell 500a may be formed over a first substrate 101, a first component layer FEOL1, a first wiring layer BEOL1, and a bonding metal layer 180 of the first semiconductor device 100.

FIG. 5A illustrates an interconnection structure region including an interconnection structure 530 and a component region including a plurality of ESD diodes 511 and 512 in the first semiconductor device 100.

The plurality of ESD diodes 521 and 522 may include active regions 110 formed on the first substrate 101, gate structures 120 disposed between the active regions 110, active contacts 131 connected to the active regions 110, and gate contacts 132 connected to the gate structures 120. A channel region 102 may be defined between the active regions 110 disposed adjacently to each other in the first direction (X-direction), and at least one of the gate structures 120 may be disposed on the channel region 102. The gate structures 120 may extend in the second direction (Y-direction). The active contacts 131 and the gate contacts 132 may be disposed in the insulating layer 161.

In an embodiment, each of the gate structures 120 includes a gate spacer 121, a gate insulating layer 122, a gate conductive layer 123, and a capping layer 124. However, the structures of each of the gate structures 120 may be variously modified according to example embodiments. For example, in consideration of a threshold voltage of each semiconductor component, a thickness and/or a material of the gate insulating layer 122 may vary, or a material and/or a stack structure of the gate conductive layer 123 may vary.

At least one of the active contacts 131 may be connected to one of the wiring patterns of the first wiring layer BEOL1 through an active via 134 disposed on an upper portion thereof. For example, an upper surface of the active via 134 may contact a lower surface of an active contact 131. Further, at least one of the gate contacts 132 may be connected to one of the wiring patterns of the first wiring layer BEOL1 through a gate via 135 disposed on an upper portion thereof. For example, an upper surface of the gate via 133 may contact a lower surface of a gate contact 132. The active via 134 and the gate via 135 may be formed inside the insulating layer 162.

The first wiring layer BEOL1 may include a plurality of metal layers M1 to M7 and a plurality of via layers V0 to V6 alternately disposed with each other. The metal layers M1 to M7 may include wiring patterns extending in the first direction (X-direction) or the second direction (Y-direction), and the via layers V0 to V6 may include vias for electrically connecting the wiring patterns in a third direction (Z-direction). Each of the plurality of metal layers M1 to M7 and the plurality of via layers V0 to V6 may include a plurality of insulating layers 163 to 176 for insulating the wiring patterns or the vias. The insulating layers may be formed of silicon oxide, silicon nitride, or silicon oxynitride, but are not limited thereto.

The active regions 110 and the gate structures 120 may be electrically connected in the first wiring layer BEOL1 to form the plurality of ESD diodes 521 and 522. For example, at least one of the active vias 134 or the gate vias 135 may be electrically connected to other active vias 134 or other gate vias 135 through wiring patterns or metal vias, thus forming the semiconductor components included in the plurality of ESD diodes 521 and 522.

In a region in which the interconnection structure 530 of the first semiconductor device 100 is provided, the first substrate 101 may include a via hole VH. For example, a portion of the first substrate 101 may be removed to form the via hole VH. A TSV 150 may be disposed in the via hole VH. The TSV 150 may fill the via hole VH. In an embodiment, the TSV 150 includes a barrier layer 152 and a conductive layer 151. The barrier layer 152 may be disposed between an internal wall of the via hole VH and the conductive layer 151. The barrier layer 152 may include titanium (Ti), titanium nitride (TiN), tantalum (Ta), tantalum nitride (TaN), ruthenium (Ru), cobalt (Co), tungsten nitride (WN), nickel (Ni), nickel boride (NiB), or any combination thereof, and may have a single-layered or multi-layered structure. The barrier layer 152 may reduce diffusion of metal of the conductive layer 151 to the substrate 100. The conductive layer 151 may be made of metal. For example, the metal may include silver (Ag), gold (Au), copper (Cu), aluminum (Al), tungsten (W), or indium (In).

A via insulating layer 153 may be interposed between the TSV 150 and the internal wall of the via hole VH. The via insulating layer 153 may include silicon oxide (SiOₓ), silicon nitride (SiNₓ), or combinations thereof, but is not limited thereto. According to other example embodiments, a polymer layer may be further disposed on the via insulating layer 153. The polymer layer may include a low dielectric constant material. For example, the polymer layer may include a fluorocarbon (CF) -based polymer material.

The TSV 150 may penetrate through the first substrate 101 and the first component layer FEOL1. One side of the TSV 150 may be connected to a bonding pad 181 of a bonding metal layer 180, and the other side of the TSV 150 may be connected to a metal pad 142 of the metal layer M1 through via patterns 141 of the via layer V0. While FIG. 5A illustrates a case in which the TSV 150 penetrates through only the first substrate 101 and the first component layer FEOL1, embodiments of the present disclosure are not limited thereto. For example, the TSV 150 may additionally penetrate through at least some of the plurality of metal layers M1 to M7 and the plurality of via layers V0 to V6.

The first substrate 101 may include an isolation film 103 surrounding the TSV 150. The isolation film 103 may be formed to prevent electrical interference between the TSV 150 and other adjacent TSVs. The isolation film 103 may be referred to as deep trench isolation (DTI). The first substrate 101 may further include an isolation film 133 for preventing electrical interference between the TSV 150 and the semiconductor components. The isolation film 133 may have a relatively shallower depth than that of the DTI from a surface on which the semiconductor component of the first substrate 101 is formed, and may be referred to as shallow trench isolation (STI).

The isolation films 103 and 133 may include silicon oxide or various insulating materials based on silicon oxide. For example, the various insulating materials may include Tetra Ethyl Ortho Silicate (TEOS), undoped Silicate Glass (USG), PhosphoSilicate Glass (PSG), Borosilicate Glass (BSG), BoroPhosphoSilicate Glass (BPSG), Fluoride Silicate Glass (FSG), Spin On Glass (SOG), Tonen SilaZene (TOSZ), or combinations thereof.

The TSV 150 and wiring patterns of the first wiring layer BEOL1 may constitute the interconnection structure 530. For example, the TSV 150 may be electrically connected to the semiconductor components of the first semiconductor device 100 through wiring patterns and via patterns connected to the metal pad 142.

In the example of FIG. 5A, the interconnection structure 530 and the plurality of ESD diodes 521 and 522 may be electrically connected to each other through a wiring pattern 143a extending from the metal layer M5 in the first direction (X-direction). However, the present disclosure is not limited to a case in which the interconnection structure 530 and the plurality of ESD diodes 521 and 522 are connected through the wiring pattern 143a of the metal layer M5. For example, the interconnection structure 530 and the plurality of ESD diodes 521 and 522 may be connected through wiring patterns extending from other metal layers M1-M4, M6 and M7.

Although not illustrated in FIG. 5A, the plurality of ESD diodes 521 and 522 and the driver 510 may also be electrically connected through wiring patterns of the metal layer M5. According to the implementation, the plurality of ESD diodes 521 and 522 may be connected to the interconnection structure 530 and the driver 510 through wiring patterns of different metal layers, respectively.

Referring to FIG. 5B, an I/O interface cell 500b may be formed over the first substrate 101, the first component layer FEOL1, the first wiring layer BEOL1, and the bonding metal layer 180 of the first semiconductor device 100, similarly to the I/O interface cell 500a described with reference to FIG. 5A.

There may be only a difference in wiring patterns of some metal layers M5 between the I/O interface cell 500a and the I/O interface cell 500b. In the example of FIG. 5B, the interconnection structure 530 and the ESD diode 521 are electrically connected through a wiring pattern 143b of the metal layer M5. However, the ESD diode 522 is not electrically connected to the interconnection structure 530. For example, the wiring pattern 143b is not additionally connected to the ESD diode 522.

Although not illustrated in FIG. 5B, the ESD diode 521 and the driver 510 may also be electrically connected through wiring patterns. However, the ESD diode 522 is not electrically connected to the driver 510.

As described with reference to FIGS. 4A and 4B, the I/O interface cell 500a and the I/O interface cell 500b may provide different ESD performance. According to an example embodiment of the present disclosure, I/O interface cells having different ESD performance may be manufactured by changing only partial wiring patterns of some metal layers in the semiconductor device. For example, the partial wiring patterns may be changed by modifying or replacing only a mask including wiring patterns of some metal layers.

On the other hand, referring to FIGS. 4A to 5B, the example embodiment of the present disclosure was described as an example of manufacturing the I/O interface cells having different ESD performance by changing the wiring pattern of the metal layer, but the present disclosure is not limited thereto. For example, the I/O interface cells having different ESD performance may be manufactured by changing the via pattern of the via layer.

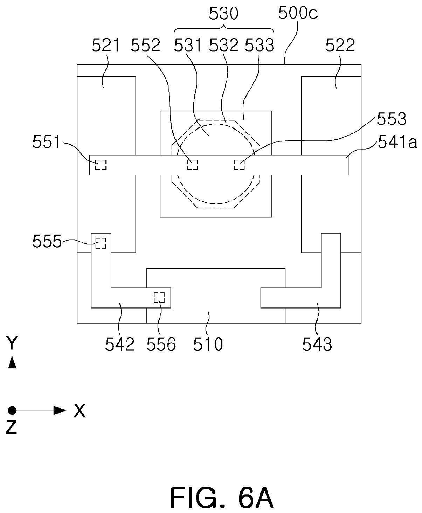

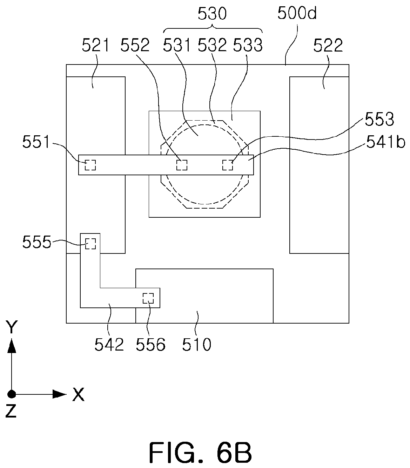

FIGS. 6A and 6B are plan views of an I/O interface cell according to an example embodiment of the present disclosure.

Referring to FIG. 6A, in an embodiment, an I/O interface cell 500c includes a driver 510, a plurality of ESD diodes 521 and 522, and an interconnection structure 530. The driver 510, the plurality of ESD diodes 521 and 522, and the interconnection structure 530 included in the I/O interface cell 500c may have the same structure as those described with reference to FIG. 4A. Further, the I/O interface cell 500c may include the same wiring patterns 541a, 542 and 543 as that of the I/O interface cell 500a described with reference to FIG. 4A.

However, an arrangement of via patterns in FIG. 6A may be different from that of FIG. 4A. For example, unlike FIG. 4A, in FIG. 6A, the fourth, seventh, and eighth via patterns 554, 557, and 558 may be excluded. For example, the fourth via pattern 554, the seventh via pattern 557, and the eighth via pattern 558 may be omitted from FIG. 6A.

In the example of FIG. 6A, the ESD diode 521 is electrically connected to the driver 510 and the interconnection structure 530, and the ESD diode 522 is electrically separated from the driver 510 and the interconnection structure 530. The I/O interface cell 500b may provide ESD performance equivalent to that of the ESD diode 521.

According to an example embodiment of the present disclosure, in a state in which the plurality of ESD diodes 521 and 522 are formed in the component layer, the via pattern for connecting the plurality of ESD diodes 521 and 522 to the interconnection structure 530 may be changed to manufacture the I/O interface cells 500a and 500c having different ESD performance. For example, the I/O interface cells 500a and 500c having the different ESD performance may be manufactured by modifying some of the plurality of via layers included in the wiring layer, for example, only a via pattern included in the via layer V4.

According to the implementation, the metal pattern and the via pattern may be modified together to manufacture the I/O interface cells having the different ESD performance.

Referring to FIG. 6B, in an embodiment, an I/O interface cell 500d includes a driver 510, a plurality of ESD diodes 521 and 522, and an interconnection structure 530 having the same structure as those of described with reference to FIG. 4A. Comparing FIGS. 4A and 6B, the metal pattern 541a and the metal pattern 541b may have different shapes, and FIGS. 4A and 6B may also be different in the presence or absence of the via patterns 554, 557 and 558. For example, a width of the metal pattern 541a may be greater than a width of the metal pattern 541b.

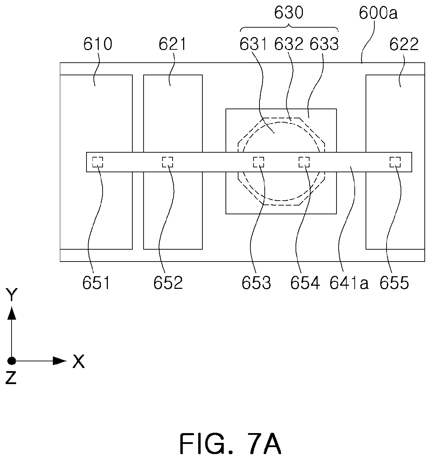

The structure of the driver and the ESD diode disposed in the component layer of the I/O interface cells is not limited to those described with reference to FIGS. 4A to 6B. The I/O interface cell may have drivers and ESD diodes disposed in various patterns. Hereinafter, the I/O interface cells according to various example embodiments of the present disclosure will be described with reference to FIGS. 7A to 9D.

FIGS. 7A to 7D are plan views of an I/O interface cell according to an example embodiment of the present disclosure.

Referring to Fig. 7A, in an embodiment, an I/O interface cell 600a includes a driver 610, a plurality ofESD diodes 621 and 622, and an interconnection structure 630. In the example of FIG. 7A, the driver 610, the plurality of ESD diodes 621 and 622, and the interconnection structure 630 may be disposed in the first direction (X-direction).

The driver 610 may include a first inverter and a plurality of second inverters, as in the driver 311 described with reference to FIG. 3. Further, the plurality of ESD diodes 621 and 622 may correspond to the ESD diode 321 described with reference to FIG. 3, each of which may include a plurality of unit diodes. According to the implementation, each of the plurality of ESD diodes 621 and 622 may have the same ESD performance or may have different ESD performance. The interconnection structure 630 may have the same structure as the interconnection structure 530 described with reference to FIG. 4A.

The driver 610, the plurality of ESD diodes 621 and 622, and the interconnection structure 630 may be electrically connected to each other through a wiring pattern 641a formed in a wiring layer and via patterns 651 to 655. For example, the via patterns 651 to 655 formed on the drivers 610, the plurality of ESD diodes 621 and 622, and the interconnection structures 630 may be arranged in the first direction (X-direction), and the wiring pattern 641a extending in the first direction (X-direction) may electrically connect the via patterns 651 to 655.

In the example of FIG. 7A, since all of the ESD diodes 621 and 622 are connected to the interconnection structure 630, the I/O interface cell 600a may provide an ESD performance equivalent to the sum of the ESD performance of each of the ESD diodes 621 and 622.

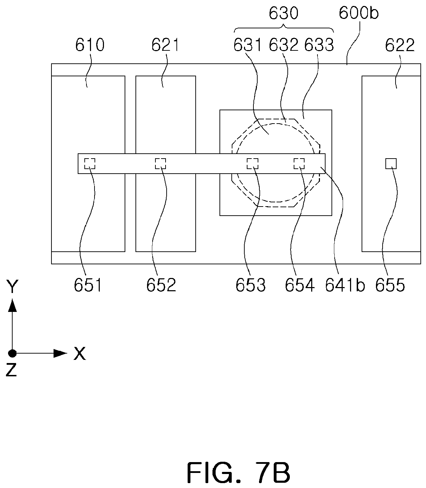

Referring to FIG. 7B, in an embodiment, an I/O interface cell 600b includes a driver 610, a plurality of ESD diodes 621 and 622, and an interconnection structure 630 having the same structure as that of the I/O interface cell 600a. Further, the I/O interface cell 600b may include a plurality of via patterns 651 to 655 electrically connected to the driver 610, the plurality of ESD diodes 621 and 622, and the interconnection structure 630, respectively.

However, an arrangement of the wiring patterns in FIG. 7B may be different from that of FIG. 7A. For example, in FIG. 7B, the wiring pattern 641b extends to electrically connect the first to fourth via patterns 551 to 554, but is electrically separated from the fifth via pattern 655. For example, a width of the wiring pattern 641b may be less than a width of the wiring pattern 641a.

Accordingly, the ESD diode 621 is electrically connected to the driver 610 and the interconnection structure 630, and the ESD diode 622 is electrically separated from the driver 610 and the interconnection structure 630. Accordingly, the I/O interface cell 600b may provide ESD performance equivalent to that of the ESD diode 621.

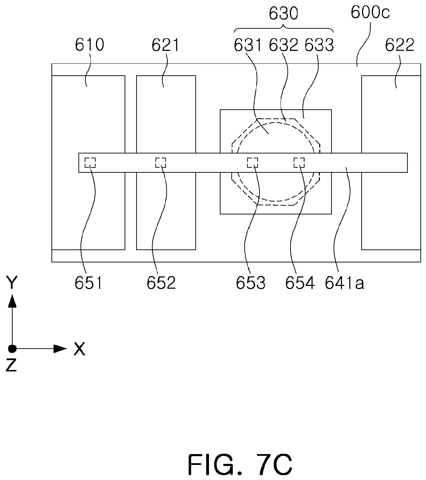

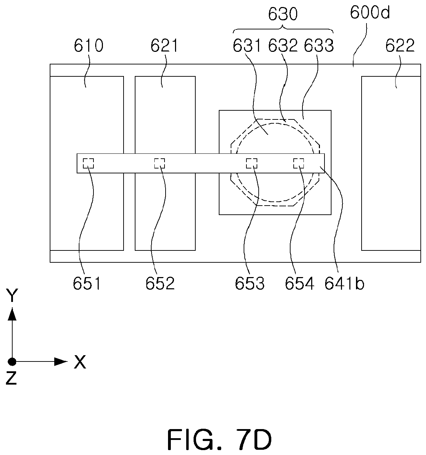

FIGS. 7C and 7D are plan views of I/O interface cells 600c and 600d having the same ESD performance as that of in FIG. 7B. In FIGS. 7C and 7D, the driver 610 and the plurality of ESD diodes 621 and 622, which are disposed in an component layer of the I/O interface cells 600c and 600d, may have the same structure as those disposed in the I/O interface cells 600a and 600b of FIGS. 7A and 7B.

The I/O interface cell 600c of FIG. 7C may have the same wiring pattern 641a as that of the I/O interface cell 600a of FIG. 7A, but the via pattern 655 is removed therefrom. For example, the via pattern 655 is omitted from the wiring pattern 641a in FIG. 7C. In FIG. 7D, the via pattern 655 is removed from the I/O interface cell 600d of FIG. 7D, and the wiring pattern 641a does not overlap the second ESD diode 622. For example, a width of the wiring pattern 641b of FIG. 7D may be less than a width of the wiring pattern 641b of FIG. 7C.

In short, in FIGS. 7A to 7D, the I/O interface cells 600a, 600b, 600c, and 600d may have components having the same structure. However, the ESD performance of the I/O interface cells 600a, 600b, 600c and 600d may vary by changing a portion of the wiring pattern or the via pattern of the I/O interface cells 600a, 600b, 600c and 600d.

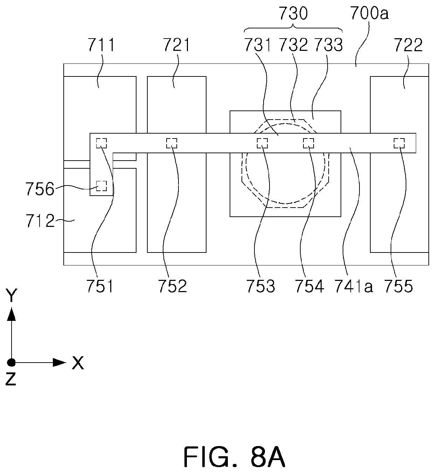

In FIGS. 4A to 7D, an example embodiment of the present disclosure has been described as an example of the I/O interface cells capable of providing different ESD performance by selectively wiring the plurality of ESD diodes. Hereinafter, referring to FIGS. 8A to 9D, an example of an I/O interface cell capable of providing different ESD performance and different driving performance by selectively wiring a plurality of ESD diodes and a plurality of drivers will be described.

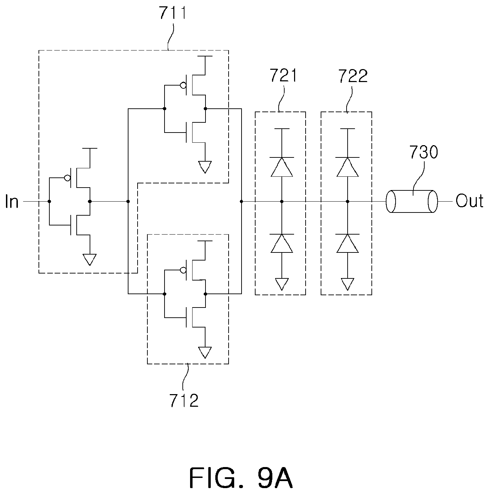

FIGS. 8A to 8D are plan views of an I/O interface cell according to an example embodiment of the present disclosure. Further, FIGS. 9A to 9D are circuit diagrams of FIGS. 8A to 8D, respectively.

Referring to FIG. 8A, an I/O interface cell 700a may include a plurality of drivers 711 and 712, a plurality of ESD diodes 721 and 722, and an interconnection structure 730.

Referring to FIG. 9A, the plurality of drivers 711 and 712 may correspond to the driver 311 described with reference to FIG. 3. For example, the driver 711 may include a first inverter and a plurality of second inverters described with reference to FIG. 3. Further, the driver 712 may include a plurality of third inverters that may be connected in parallel to the plurality of second inverters of the driver 711. FIG. 9A illustrates, for example, one second inverter and one third inverter that may be included in the drivers 711 and 712.

In an embodiment, the number of second inverters included in the plurality of drivers 711 and 712 is identical to the number of third inverters. For example, when all of the plurality of drivers 711 and 712 are used, driving performance may be twice as much as when only the driver 711 are used. However, the present disclosure is not limited to a case in which the number of second inverters and the number of third inverters included in each of the plurality of drivers 711 and 712 are identical to each other.

The plurality of ESD diodes 721 and 722 may correspond to the ESD diode 321 described with reference to FIG. 3. For example, the ESD diode 721 may include first unit diodes, and the ESD diode 722 may include second unit diodes. FIG. 9A illustrate one first unit diode and one second unit diode that may be included in the plurality of ESD diodes 721 and 722. According to the implementation, each of the multiple ESD diodes 721 and 722 may have the same ESD performance or may have different ESD performance. For example, the number of first unit diodes and the number of second unit diodes may be identical to each other or may be different from each other.

Referring to FIG. 8A, the plurality of drivers 711 and 712, the plurality of ESD diodes 721 and 722, and the interconnection structure 730 may be electrically connected to each other through a wiring pattern 741a formed in a wiring layer and via patterns 751 to 756. For example, driver 711 may be connected to via pattern 751, ESD diode 721 may be connected to via pattern 752, interconnection structure 730 may be connected to via patterns 753 and 754, a first ESD diode 722 may be connected to via pattern 755 and driver 712 may be connected to via pattern 756. In an embodiment, wiring pattern 741a is L shaped. For example, the wiring pattern 741 may include a first section extending in the Y-direction and a second section extending in the X-direction.

Referring to FIG. 9A, since the plurality of drivers 711 and 712, the plurality of ESD diodes 721 and 722, and the interconnection structure 730 are connected to each other, the I/O interface cell 700a may provide driving performance equivalent to the sum of driving performance of the plurality of drivers 711 and 712, and may provide ESD performance equivalent to the sum of ESD performance of each of the ESD diodes 721 and 722.

In the I/O interface cell 700a of FIG. 8A, the I/O interface cells having different driving performance or different ESD performance may be provided by changing the wiring pattern.

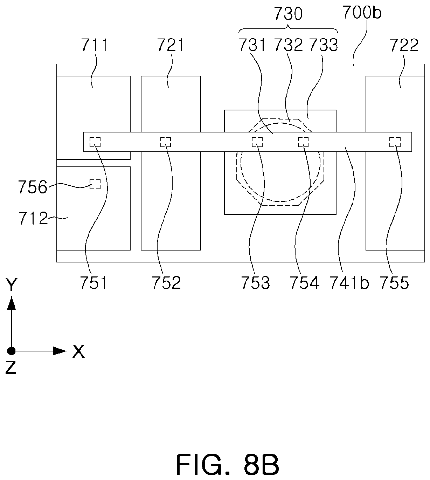

In FIGS. 8B to 8D, the I/O interface cells 700b, 700c and 700d may include the plurality of drivers 711 and 712, the ESD diodes 721 and 722, and the interconnection structure 730 having the same structure as those of the I/O interface cell 700a described with reference to FIG. 8A.

Referring to FIG. 8B, a wiring pattern 741b may electrically connect the first to fifth via patterns 751 to 755 connected to the driver 711, the ESD diodes 721 and 722, and the interconnection structure 730, respectively. However, the wiring pattern 741b is electrically separated from the sixth via pattern 756 connected to the driver 712. For example, the wiring pattern 741b may not include a section extending in the Y-direction.

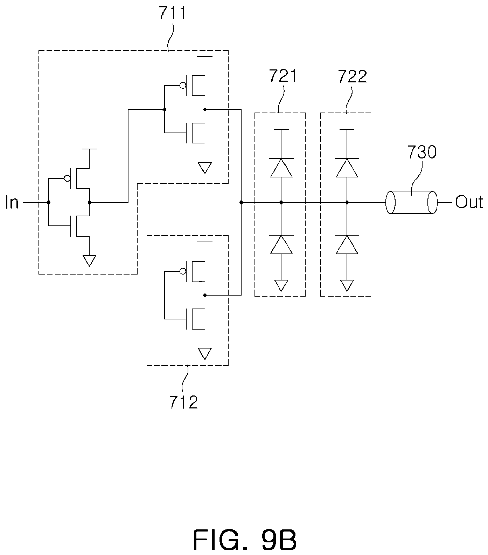

Referring to FIG. 9B, the driver 712 is electrically separated from the ESD diodes 721 and 722 and the interconnection structure 730. Accordingly, the I/O interface cell 700b may provide driving performance corresponding to the driving performance of the driver 711, for example, half of the driving performance of the I/O interface cell 700a.

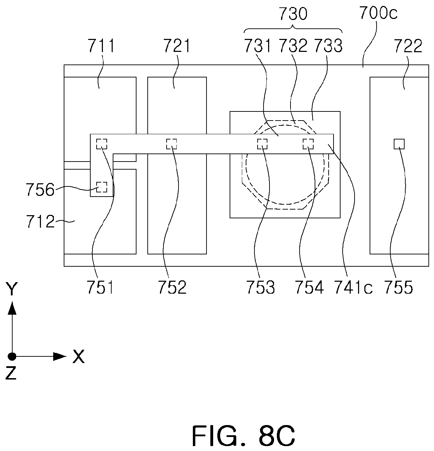

Referring to FIG. 8C, a wiring pattern 741c may electrically connect the via patterns 751 to 754 and 756 connected to the plurality of drivers 711 and 721, the ESD diode 721, and the interconnection structure 730, respectively. However, the wiring pattern 741c is electrically separated from the fifth via pattern 755 connected to the ESD diode 722.

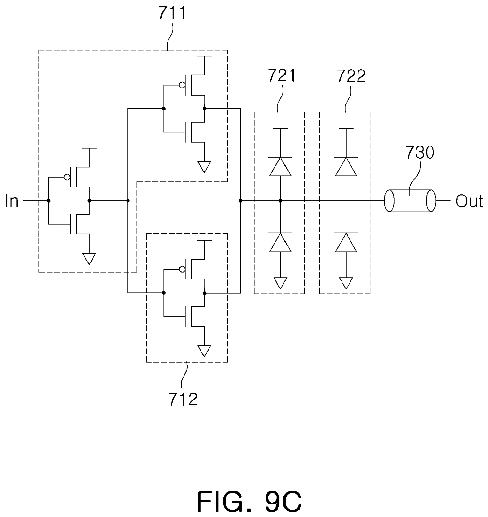

Referring to FIG. 9C, the ESD diode 722 is electrically separated from the drivers 711 and 712 and the interconnection structure 730. Accordingly, the I/O interface cell 700c may provide ESD performance corresponding to the ESD performance of the ESD diode 721, for example, half of the ESD performance of the I/O interface cell 700a.

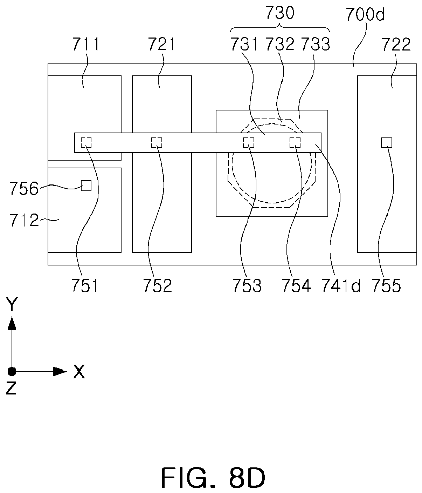

Referring to FIG. 8D, a wiring pattern 741d may electrically connect the first to fourth via patterns 751 to 754 connected to the driver 711, the ESD diode 721, and the interconnection structure 730. However, the wiring pattern 741d is electrically separated from the sixth via pattern 756 connected to the driver 712 and the fifth via pattern 755 connected to the ESD diode 722.

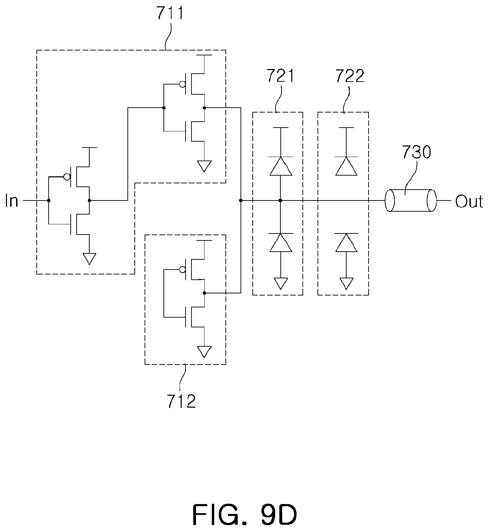

Referring to FIG. 9D, only the driver 711 and the ESD diode 721 are electrically connected to the interconnection structure 730. Accordingly, the I/O interface cell 700d may provide driving performance corresponding to the driving performance of the driver 711 and ESD performance corresponding to the ESD performance of the ESD diode 721.

Referring to FIGS. 8A to 9D, I/O interface cells having different driving performance or different ESD performance may be manufactured by changing wiring patterns of the plurality of drivers 711 and 712 and the plurality of ESD diodes 721 and 722 having a predetermined structure in an component layer. However, the present disclosure is not limited to changing the wiring patterns to manufacture the I/O interface cells having different driving performance or different ESD performance, and may be subject to a change in the via patterns.

According to the implementation, the component layer of the I/O interface cell region may include three or more drivers or three or more ESD diodes. The I/O interface cell may be generated by connecting at least some of the three or more drivers and at least some of the three or more ESD diodes to the interconnection structure depending on via patterns and wiring patterns of the wiring layer of the I/O interface cell region. The generated I/O interface cell may have various driving performance and various ESD performance depending on the number and the driving performance of connected drivers, the number of connected ESD diodes, and the ESD performance.

According to an example embodiment of the present disclosure, the I/O interface cell may be manufactured to have various driving performance and various ESD performance according to the via patterns and the wiring patterns of the wiring layer, thereby improving utilization of the I/O interface cell.

Meanwhile, as described referring to FIG. 1, the first semiconductor device 100 may include a plurality of I/O interface cells including the I/O interface cells 301 and 302. According to the implementation, some of the plurality of I/O interface cells may have ESD performance or driving performance different from those of the others thereof.

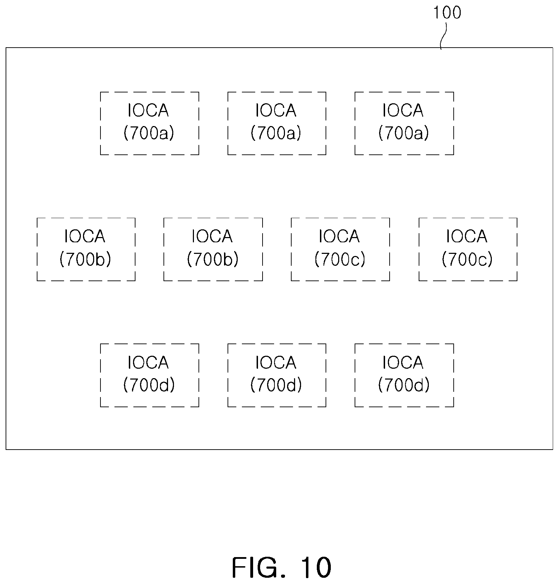

FIG. 10 is a plan view of a semiconductor device according to an example embodiment of the present disclosure.

Referring to FIG. 10, a plurality of I/O interface cell regions IOCA may be defined in the first semiconductor device 100. I/O interface cells having different ESD performance or driving performance may be disposed in the plurality of I/O interface cell regions IOCA.

For example, one of the I/O interface cells 700a, 700b, 700c and 700d described with reference to FIGS. 8A to 9D may be disposed in each of the plurality of I/O interface cell regions.

Each of the I/O interface cell regions IOCA may include semiconductor components having the same structure in the component layer and having the same relative position. For example, each of the I/O interface cell regions IOCA may include a plurality of drivers 711 and 712, a plurality of ESD diodes 721 and 722, and an interconnection structure 730 having the same structure as each other and the same relative position as each other.

Different wiring patterns or different via patterns may be formed in the wiring layers of the I/O interface cell regions in which different I/O interface cells 700a, 700b, 700c and 700d are arranged. As a first example, the wiring patterns may be disposed in the same relative position in the I/O interface cell regions, but the via patterns may be electrically separated from the driver 712 or the ESD diode 722. As a second example, the via patterns may be disposed in the same relative position, but the wiring patterns may be electrically separated from the via patterns connected to the driver 712 or the ESD diode 722.

According to an example embodiment of the present disclosure, the same semiconductor devices may be formed in the I/O interface cell regions IOCA to manufacture the first semiconductor device 100, and the wiring of the semiconductor components may be changed according to the ESD performance or the driving performance required for the I/O interface cells.

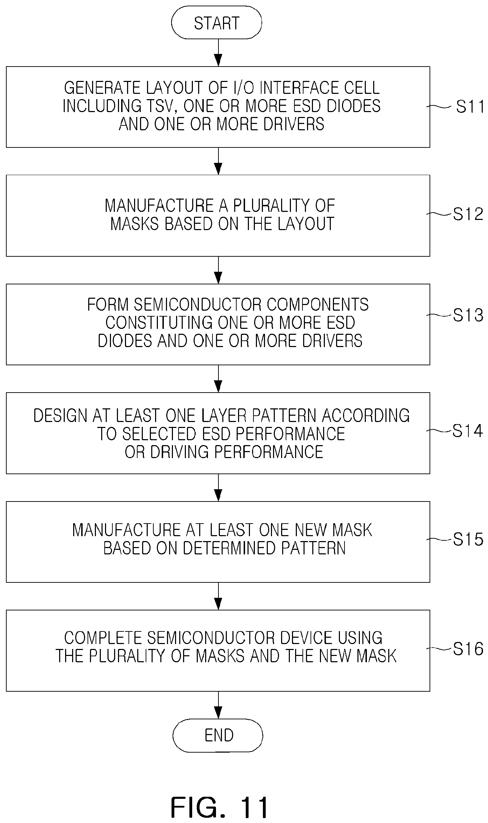

FIG. 11 is a flowchart illustrating a manufacturing method of a semiconductor device according to an example embodiment of the present disclosure.

In step S11, a layout of the semiconductor device may be generated by performing an arrangement and routing. For example, a plurality of I/O interface cell regions may be defined in the semiconductor substrate. Further, one or more drivers, one or more ESD diodes, and an interconnection structure may be formed in each of the I/O interface cell regions. At least one of the driver and the ESD diode may be disposed in a plural form in the I/O interface cell region.

According to an example embodiment, the one or more drivers, the one or more ESD diodes, and the interconnection structure are formed in the same relative position in each of the plurality of I/O interface cell regions.

According to an example embodiment, a position of the one or more drivers and the one or more ESD diodes is determined based on the KOZ around the TSV included in the interconnection structure.

In step S12, a plurality of masks are manufactured based on the layout of the semiconductor device. For example, the layout of a semiconductor device may have a structure in which a plurality of layers are stacked on each of the component layer and the wiring layer, and the plurality of masks having patterns to be formed on each of the plurality of layers may be manufactured.

In step S13, the plurality of masks may be used to form semiconductor components constituting one or more ESD diodes and one or more drivers in each of the plurality of I/O interface cell regions. For example, by performing processes such as deposition, etching, and implantation on the semiconductor substrate using the plurality of masks, desired patterns may be formed on each of the plurality of layers forming the semiconductor device.

During an operation of manufacturing the semiconductor device in step S 13, or before and after the operation, the ESD performance of the diode or the driving performance of the driver may be determined or changed. For example, ESD performance or driving performance may be changed during or after the manufacture of components forming the ESD diode and components forming the driver in the semiconductor device.

In step S14, a pattern of at least one layer is designed according to the selected ESD performance or the selected driving performance. Wiring patterns or via patterns for connecting the plurality of ESD diodes or the plurality drivers to the interconnection structure disposed in the I/O interface cell regions may be determined or modified in the designing of the pattern or the layer. When the ESD performance or the driving performance for the I/O interface cell to be disposed in the I/O interface cell regions is different from each other, the wiring patterns or the via patterns of each of the I/O interface cell regions may be designed differently.

In step S15, at least one new mask is manufactured based on the determined pattern. For example, a mask corresponding to the wiring layer or the via layer including the determined pattern may be manufactured. In the example of FIG. 5A, when a wiring pattern of a wiring layer M5 is determined, a new mask for forming the patterns of the wiring layer M5 may be manufactured.

In step S16, manufacture of the semiconductor device is completed by forming the wiring patterns and the via patterns using the plurality of masks and the new masks. For example, when a new mask corresponding to the wiring layer M5 is manufactured, a mask corresponding to the wiring layer M5 among the masks manufactured in step S12 may be replaced with the new mask. Masks corresponding to layers except for the wiring layer M5 may be used unchangeably, and layers already manufactured on the wafer may also be used unchangeably.

According to an example embodiment of the present disclosure, a redundancy ESD diode or a redundancy driver may be formed in the I/O interface cell for the ECO, and only some new masks may be manufactured as necessary to connect the redundancy ESD diode or the redundancy driver to the interconnection structure. Depending on whether the redundancy ESD diode or the redundancy driver is connected, the I/O interface cell may have various ESD performance or various driving performance, thereby increasing utilization of the I/O interface cell.

According to an example embodiment of the present disclosure, a plurality of masks except for the new mask may be reused, thereby reducing design costs of I/O interface cells having various ESD performance or various driving performance. Further, even if there is an ECO that changes ESD performance or driving performance during the manufacturing process of the semiconductor device, the semiconductor device may be completed using the manufactured plurality of masks unchangeably, thereby reducing manufacturing time and costs of the semiconductor device.

The present disclosure is not limited to the above-described embodiments and the accompanying drawings. Therefore, those of ordinary skill in the art may make various replacements, modifications, or changes without departing from the scope of the present disclosure, and these replacements, modifications, or changes should be construed as being included in the scope of the present disclosure.

The following numbered clauses exemplify aspects of the invention:
1. A semiconductor device comprising:
   a first input/output (I/O) interface cell region having a plurality of first electrostatic discharge (ESD) diode arrangements, a first driver and a first through silicon via (TSV) disposed therein and having first wiring patterns and first via patterns for electrically connecting the plurality of first ESD diode arrangements, the first driver and the first TSV; and
   a second I/O interface cell region having a plurality of second ESD diode arrangements, a second driver and a second TSV disposed therein and having second wiring patterns and second via patterns for electrically connecting the second driver, the second TSV and a subset of the plurality of second ESD diode arrangements, wherein the second ESD diode arrangements other than the subset are electrically separated from the second driver and the second TSV,
   wherein the plurality of first ESD diode arrangements and the plurality of second ESD diode arrangements, the first driver and the second driver, and the first TSV and the second TSV have a same structure, and are disposed in a same relative position in the first I/O interface cell region and the second I/O interface cell region.
2. The semiconductor device of clause 1, wherein the first wiring patterns and the second wiring patterns are disposed in a same relative position in the first I/O interface cell region and the second I/O interface cell region, and
   the second via patterns include via patterns for connecting the subset of the second ESD diode arrangements to at least one of the second wiring patterns, and are electrically separated from the second ESD diode arrangements other than the subset.
3. The semiconductor device of clause 1, wherein the first via patterns and the second via patterns are disposed in a same relative position in the first I/O interface cell region and the second I/O interface cell region, and
   the second wiring patterns include at least one wiring pattern configured to electrically connect the subset of the second ESD diode arrangements, the second driver and the second TSV, and electrically separated from via patterns connected to the second ESD diode arrangements other than the subset.
4. The semiconductor device of any preceding clause, wherein each of the plurality of first ESD diode arrangements has a same ESD performance.
5. The semiconductor device of any preceding clause, wherein each of the plurality of first ESD diode arrangements has a same number of unit diodes.
6. The semiconductor device of any preceding clause, wherein the first driver, the plurality of first ESD diode arrangements, and the first TSV are disposed in a first direction parallel with a plane on which the first I/O interface cell region is defined.
7. The semiconductor device of any of clauses 1 to 6, wherein the plurality of first ESD diode arrangements and the first TSV are arranged in a first direction parallel with a plane on which the first I/O interface cell region is defined, and the first driver is disposed adjacent to the first TSV in a second direction parallel with the plane and intersecting the first direction.
8. The semiconductor device of clause 7, wherein the plurality of first ESD diode arrangements are spaced apart from the first TSV by a first distance, and
   the first driver is spaced apart from the first TSV by a second distance longer than the first distance.
9. The semiconductor device of any preceding clause, wherein each of the first driver and the second driver includes a first inverter and a plurality of second inverters connected in parallel to an output terminal of the first inverter,
   wherein the first I/O interface cell region further comprises:
   a third driver including a plurality of third inverters connected in parallel to each other, and
   the second I/O interface cell region further comprises:
      a fourth driver including a plurality of fourth inverters connected in parallel to each other.
10. The semiconductor device of clause 9, wherein a number of the plurality of second inverters, a number of the plurality of third inverters, and a number of the plurality of fourth inverters are identical to each other.
11. The semiconductor device of clause 9 or 10, wherein the first wiring patterns and the first via patterns include wiring patterns and via patterns for connecting the plurality of third inverters in parallel to the plurality of second inverters.
12. The semiconductor device of any of clauses 9 to 11, wherein the second wiring patterns and the second via patterns are electrically separated from the plurality of fourth inverters.
13. A manufacturing method of a semiconductor device, the method comprising:
   generating a layout by defining a plurality of input/output (I/O) interface cell regions in a semiconductor substrate and disposing a plurality of electrostatic discharge (ESD) diode arrangements, one or more drivers, and a through silicon via (TSV) in each of the plurality of I/O interface cell regions;
   manufacturing a plurality of masks based on the layout;
   forming semiconductor components constituting the plurality of ESD diode arrangements and the one or more drivers in the I/O interface cell regions using the plurality of masks;
   determining ESD performance for each of the plurality of I/O interface cell regions;
   designing patterns of each of the plurality of I/O interface cell regions according to the determined ESD performance;
   manufacturing at least one new mask based on the designed patterns; and
   completing the semiconductor device by forming wiring patterns and via patterns of the semiconductor device using the plurality of masks and the new mask.
14. The manufacturing method of the semiconductor device of clause 13, wherein the generating of the layout comprises:
   disposing the plurality of ESD diode arrangements, the one or more drivers, and the TSV to have a same relative position in each of the plurality of I/O interface regions.
15. The manufacturing method of the semiconductor device of clause 14, wherein the generating of the layout comprises:
   determining positions of the plurality of ESD diode arrangements and the one or more drivers based on a Keep-Out Zone (KOZ) around the TSV.

## Claims

1. A semiconductor device comprising:
a first input/output (I/O) interface cell region having a plurality of first electrostatic discharge (ESD) diode arrangements, a first driver and a first through silicon via (TSV) disposed therein and having first wiring patterns and first via patterns for electrically connecting the plurality of first ESD diode arrangements, the first driver and the first TSV; and
a second I/O interface cell region having a plurality of second ESD diode arrangements, a second driver and a second TSV disposed therein and having second wiring patterns and second via patterns for electrically connecting the second driver, the second TSV and a subset of the plurality of second ESD diode arrangements, wherein the second ESD diode arrangements other than the subset are electrically separated from the second driver and the second TSV,
wherein the plurality of first ESD diode arrangements and the plurality of second ESD diode arrangements, the first driver and the second driver, and the first TSV and the second TSV have a same structure, and are disposed in a same relative position in the first I/O interface cell region and the second I/O interface cell region.

2. The semiconductor device of claim 1, wherein the first wiring patterns and the second wiring patterns are disposed in a same relative position in the first I/O interface cell region and the second I/O interface cell region, and
the second via patterns include via patterns for connecting the subset of the second ESD diode arrangements to at least one of the second wiring patterns, and are electrically separated from the second ESD diode arrangements other than the subset.

3. The semiconductor device of claim 1, wherein the first via patterns and the second via patterns are disposed in a same relative position in the first I/O interface cell region and the second I/O interface cell region, and
the second wiring patterns include at least one wiring pattern configured to electrically connect the subset of the second ESD diode arrangements, the second driver and the second TSV and electrically separated from via patterns connected to the second ESD diode arrangements other than the subset.

4. The semiconductor device of any preceding claim, wherein each of the plurality of first ESD diode arrangements has a same ESD performance.

5. The semiconductor device of any preceding claim, wherein each of the plurality of first ESD diode arrangements has a same number of unit diodes.

6. The semiconductor device of any preceding claim, wherein the first driver, the plurality of first ESD diode arrangements, and the first TSV are disposed in a first direction parallel with a plane on which the first I/O interface cell region is defined.

7. The semiconductor device of any of claims 1 to 6, wherein the plurality of first ESD diode arrangements and the first TSV are arranged in a first direction parallel with a plane on which the first I/O interface cell region is defined, and the first driver is disposed adjacent to the first TSV in a second direction parallel with the plane and intersecting the first direction.

8. The semiconductor device of claim 7, wherein the plurality of first ESD diode arrangements are spaced apart from the first TSV by a first distance, and
the first driver is spaced apart from the first TSV by a second distance longer than the first distance.

9. The semiconductor device of any preceding claim, wherein each of the first driver and the second driver includes a first inverter and a plurality of second inverters connected in parallel to an output terminal of the first inverter,
wherein the first I/O interface cell region further comprises:
a third driver including a plurality of third inverters connected in parallel to each other, and
the second I/O interface cell region further comprises:
a fourth driver including a plurality of fourth inverters connected in parallel to each other.

10. The semiconductor device of claim 9, wherein a number of the plurality of second inverters, a number of the plurality of third inverters, and a number of the plurality of fourth inverters are identical to each other.

11. The semiconductor device of claim 9 or 10, wherein the first wiring patterns and the first via patterns include wiring patterns and via patterns for connecting the plurality of third inverters in parallel to the plurality of second inverters.

12. The semiconductor device of any of claims 9 to 11, wherein the second wiring patterns and the second via patterns are electrically separated from the plurality of fourth inverters.

13. A manufacturing method of a semiconductor device, the method comprising:
generating a layout by defining a plurality of input/output (I/O) interface cell regions in a semiconductor substrate and disposing a plurality of electrostatic discharge (ESD) diode arrangements, one or more drivers, and a through silicon via (TSV) in each of the plurality of I/O interface cell regions;
manufacturing a plurality of masks based on the layout;
forming semiconductor components constituting the plurality of ESD diode arrangements and the one or more drivers in the I/O interface cell regions using the plurality of masks;
determining ESD performance for each of the plurality of I/O interface cell regions;
designing patterns of each of the plurality of I/O interface cell regions according to the determined ESD performance;
manufacturing at least one new mask based on the designed patterns; and
completing the semiconductor device by forming wiring patterns and via patterns of the semiconductor device using the plurality of masks and the new mask.

14. The manufacturing method of the semiconductor device of claim 13, wherein the generating of the layout comprises:
disposing the plurality of ESD diode arrangements, the one or more drivers, and the TSV to have a same relative position in each of the plurality of I/O interface regions.

15. The manufacturing method of the semiconductor device of claim 14, wherein the generating of the layout comprises:
determining positions of the plurality of ESD diode arrangements and the one or more drivers based on a Keep-Out Zone (KOZ) around the TSV
